# EUROPÄISCHE PATENTSCHRIFT

(11) **EP 2 823 119 B1**
(45) Veröffentlichungstag und Bekanntmachung des Hinweises auf die Patenterteilung: **12.04.2017**
(21) Anmeldenummer: 13706255.0
(22) Anmeldetag: 25.02.2013
(51) Int. Cl.: E05B 77/34, E05B 81/76, E05B 81/78, E05B 85/16

(54) **FAHRZEUGTÜRGRIFF MIT KAPAZITIVEM ANNÄHERUNGSSENSOR**
VEHICLE DOOR HANDLE WITH CAPACITIVE PROXIMITY SENSOR
POIGNÉE DE PORTE DE VÉHICULE ÉQUIPÉE D'UN DÉTECTEUR DE PROXIMITÉ CAPACITIF

(30) Priorität: 06.03.2012 DE 102012101882
(43) Veröffentlichungstag der Anmeldung: 14.01.2015
(73) Patentinhaber: Huf Hülsbeck & Fürst GmbH & Co. KG, 42551 Velbert (DE)
(72) Erfinder: WITTE, Martin, 48683 Ahaus (DE); PESCHL, Andreas, 42555 Velbert (DE)
(74) Vertreter: Zenz Patentanwälte Partnerschaft mbB
(86) Internationale Anmeldenummer: PCT/EP2013/053697
(87) Internationale Veröffentlichungsnummer: WO 2013/131770

(56) Entgegenhaltungen:
- EP-A1- 1 349 280
- WO-A1-2008/107046
- DE-A1-102004 019 627
- US-A1- 2005 236 846

## Beschreibung

Die Erfindung betrifft eine Türbetätigungsanordnung mit Sensormitteln zur Erfassung einer Benutzerannäherung. Insbesondere betrifft die Erfindung Türgriffsysteme mit kapazitiven Annäherungssensoren.

Derartige kapazitive Sensorsysteme sind in der Technik bekannt und können berührungslos die Annäherung eines Benutzers erfassen. Dazu wird die Veränderung der Kapazität einer Elektrodenanordnung gemessen, welche u.a. von der Nähe des Körperteils eines Benutzers abhängig ist. Eine beispielhafte Anordnung ist der DE 10 2005 061 755 A1 zu entnehmen.

Derartige Sensorsysteme werden im Stand der Technik für "Passive Entry"-Systeme verwendet, bei denen der Benutzer nicht mehr aktiv eine Taste einer Funkfernbedienung zum Zugang zu einem Fahrzeug zu betätigen braucht. Vielmehr reicht es aus, dass der Benutzer die als ID-Geber (Identifikationsgeber) bezeichnete Funkfernbedienung mit sich führt (in einer Tasche der Bekleidung oder einer Aktentasche beispielsweise). Hierbei wird mittels eines Annäherungssensors die Annäherung des Benutzers an die Tür des Kraftfahrzeugs erfasst, woraufhin ein in dem Kraftfahrzeug angeordnetes Steuergerät über eine (beispielsweise in einem Türgriff angeordnete) Sendeantenne ein Funksignal an den beim Benutzer befindlichen ID-Geber sendet, das den ID-Geber "aufwecken" soll. Nach Empfang des Aufwecksignals beginnt ein Funkdialog zwischen dem ID-Geber und dem Steuergerät des Kraftfahrzeugs, in dessen Ergebnis die Berechtigung oder Nicht-Berechtigung des ID-Gebers festgestellt wird. Wird die Berechtigung des ID-Gebers festgestellt, so wird das Türschloss entriegelt, so dass durch eine anschließende Betätigung des Türgriffs das Türschloss geöffnet werden kann. Als Annäherungssensor wird beispielsweise einer der genannten kapazitiven Sensoren verwendet.

Es ist im Übrigen bekannt, dass solche Sensoranordnungen wetterabhängig und abhängig von übrigen Umgebungsbedingungen sind. Denn die Luftfeuchte, Niederschläge und sonstige Einflüsse verändern ebenfalls die Kapazität des Sensorsystems.

Beim Einsatz eines kapazitiven Sensors zum Erfassen der Annäherung eines Benutzers ist es daher problematisch, die Annäherung eines Bedienerkörperteils, beispielsweise einer Hand, an den Türgriff zum Zweck des Öffnens der Tür bei solchen Störeinflüssen zweifelsfrei festzustellen.

Türgriffsysteme, in welche kapazitive Annäherungssensoren integriert sind, die gegenüber Umgebungseinflüssen geschützt ausgebildet sind, sind im Stand der Technik bekannt. Beispielsweise offenbart die EP 03 100 728.9 (Veröffentlichungsnummer EP 1 349 280 A1) ein System, welches eine kapazitive Sensoranordnung hinter einer Gehäusewandung anordnet. Der Raum zwischen der Sensoranordnung und der Gehäusewandung wird mit einem elektrisch isolierenden Material gefüllt, um ein Eintreten von Feuchtigkeit oder sonstigen Fremdstoffen zu verhindern.

Insbesondere nahe der Elektroden eines kapazitiven Sensors ist der Einfluss störenden Effekte möglichst zu vermeiden. Kapazitive Sensoren können deswegen insbesondere in Vergussmassen eingebettet werden, um eine unmittelbare Beeinflussung der Sensorflächen zu verhindern. Der vorstehende Stand der Technik füllt außerdem den gesamten Raum zwischen solch einer vergossenen Elektrodenanordnung und einer Wandung eines Türgriffs mit isolierendem Material.

Aus der WO 2008/107046 ist ein Fahrzeugtürgriff bekannt, bei dem ein Dichtmittel in den Griffkörper eingebracht ist, welches beim montieren des Griffs dichtend komprimiert wird.

Nachteilig an dem System ist es jedoch, dass der Einfluss dieses Materials, auch wenn er noch schädlichere Einflüsse von dem Detektionsbereich abhält, der Detektionsempfindlichkeit abträglich ist. Denn auch wenn das Material ein elektrisch isolierendes Material ist, so ist es dennoch ein die Kapazität beeinflussendes Dielektrikum.

Im Übrigen ist die Griffanordnung stark wechselnden Umgebungsbedingungen und Umgebungstemperaturen ausgesetzt, so dass bei den Lösungen gemäß dem Stand der Technik regelmäßig durch Größenänderungen Spalte entstehen, in die dann doch Substanzen eindringen können oder in denen eine Kondensation von Flüssigkeit stattfindet.

Aufgabe der Erfindung ist es, eine flüssigkeits- und kondensationsunabhängige Sensoreinrichtung bereitzustellen, welche eine verbesserte Detektionsempfindlichkeit aufweist.

Gemäß der Erfindung weist eine Türgriffeinrichtung für Kraftfahrzeuge einen Griffkörper und eine Abdeckung für den Griffkörper auf, wobei der Griffkörper und die Abdeckung eine Handhabe für einen Benutzer bilden.

Zwischen Griffkörper und Abdeckung ist ein Aufnahmeraum zur Aufnahme von elektronischen Komponenten gebildet.

Ein kapazitiver Annäherungssensor ist in dem Aufnahmeraum angeordnet, wobei der Annäherungssensor eine zu der Abdeckung gerichtete aktive kapazitive Fläche zur Erfassung von Annäherungen aufweist, wobei die Annäherungen durch die Abdeckung hindurch erfassbar sind.

Die kapazitive Fläche ist zur Erfassung von Annäherungen mit einer Auswerteschaltung gekoppelt, welche Veränderungen in der Kapazität der kapazitiven Fläche erfasst.

In dem Aufnahmeraum ist ein Dichtmittel angeordnet, welches zwischen Abdeckung und Griffkörper oder zwischen Abdeckung und den im Griffkörper aufgenommenen Komponenten dichtend komprimiert ist.

Erfindungsgemäß wird bei einer Griffeinrichtung der eingangs genannten Art demnach vorgeschlagen, dass das Dichtmittel aus einem geschlossen-zelligen Schaumstoff gebildet ist und wenigstens eine vom Rand des Dichtmittels beabstandete durchgehende Öffnung aufweist, wobei die durchgehende Öffnung des Dichtmittels über der aktiven Fläche des Annäherungssensors angeordnet ist, so dass wenigstens ein Bereich über der aktiven Fläche des Annäherungssensors frei von Schaumstoff ist.

Es wird demnach vorgeschlagen, bei einer Griffeinrichtung der eingangs genannten Art eine elastische Dichtung einzubringen, welche eine durchgehende innere freie Öffnung aufweist. Dies bedeutet, dass sich das elastische Dichtmaterial ringförmig und allseitig um die freie Öffnung erstreckt. Die innere freie Öffnung ist über der aktiven Fläche des kapazitiven Anwesenheitssensors angeordnet. Die elastische Dichtung ist in ihrer Dickenabmessung, also in der Richtung zwischen kapazitivem Sensor und Abdeckung so bemessen, dass sie bei Aufbringen der Abdeckung über der kapazitiven Sensoranordnung komprimiert wird. Die Dickenabmessung der Dichtung ist also im unkomprimierten Zustand größer, als der durch die Dichtung eingenommene Abstand im montierten Endzustand.

Bei dem elastischen Dichtmaterial handelt es sich um einen geschlossen-zelligen Schaumstoff, welcher dichtend gegenüber Flüssigkeiten, Fetten und sonstigen Fremdstoffen wirkt.

Erfindungsgemäß werden also einerseits die elastischen Eigenschaften des Schaumstoffes genutzt, um jederzeit eine dichtende Verbindung zwischen Abdeckung der Türgriffanordnung und Sensoreinrichtung bereitzustellen. Dies geschieht, indem der Schaumstoff bei der Montage komprimiert wird und so unter gewisser Vorspannung die Dichtposition einnimmt. Auch Temperaturschwankungen können auf diese Weise nicht zu der Freigabe von Spaltöffnungen führen.

Des Weiteren ist die Bildung einer ringförmigen Abdichtung mit einem freien Innenraum über der aktiven Fläche des kapazitiven Sensors geeignet, die Detektionsgenauigkeit der Sensoranordnung zu verbessern. Da im freien Bereich weitestgehend konstante Bedingungen herrschen, ist eine Nachkalibrierung nur für die Bedingungen erforderlich, die außerhalb der Türgriffanordnung ihren Ursprung haben. Der besonders empfindliche Bereich unmittelbar oberhalb der aktiven Detektionsfläche wird durch die erfindungsgemäße Rundum-Abdichtung vor schädlichen Einflüssen geschützt.

Die Verbesserung der Detektionsgenauigkeit resultiert schließlich wieder in einer Verminderung des Energiebedarfs der Detektionseinrichtung.

Als dichtende Schaumstoffe kommen beliebige am Markt verfügbare Dichtschaumstoffe infrage, z.B. Vinyl-Schaumstoffe, welche eine gute Abdichtung gegen Feuchtigkeit bieten. In derartige Schaumstoffe ist eine durchgehende Öffnung, z.B. durch Stanzen oder Schneiden einzubringen, welche über der aktiven Fläche der kapazitiven Sensoreinrichtung platziert wird.

Die kapazitive Sensoranordnung ist mit einer Sensorelektrode ausgestattet, mit deren Hilfe die Annäherung eines Objekts erfasst wird. Die mit der Sensorelektrode gekoppelte Steuer- und Auswerteschaltung erfasst eine Änderung der Kapazität der Sensorelektrode gegenüber Masse, indem sie die Sensorelektrode mit einer vorgegebenen Frequenz periodisch wiederholt mit einer Betriebsspannung koppelt und wenigstens einen Parameter eines vom periodischen Laden und Entladen der Sensorelektrode abhängigen Strom- oder Spannungsverlaufs zur Erfassung der Kapazitätsänderung auswertet (siehe z.B. US 5,730,165 oder DE 196 81 725). Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird.

Es ist in diesem Zusammenhang zu beachten, dass die Anordnung des dichtenden Schaumstoffes so erfolgt, dass keine störenden Einflüsse eindringen können. Es ist dabei nicht gesagt, dass der dichtende Schaumstoff unmittelbar auf der aktiven Fläche, z.B. der Elektrodenfläche der kapazitiven Sensoranordnung platziert wird. Da kapazitive Sensoranordnungen oft in isolierendem Material vergossen sind, kann die Dichtung auch auf dem Vergussmaterial zur Dichtung dieses vergossenen Systems gegenüber den äußeren Abdeckungen angeordnet werden. Wesentlich ist lediglich, dass der Schaumstoff unter Spannung in diesen Bereich eingebracht wird und die innere freie Fläche über der aktiven Fläche der kapazitiven Sensoranordnung platziert wird.

In einer vorteilhaften Weiterbildung der Erfindung wird in den inneren freien Raum des Schaumstoffes ein hygroskopisches Material als Absorptionsmaterial eingebracht.

Um den inneren freien Bereich, welcher umgebend durch Schaumstoff gedichtet wird, die Restfeuchte zu entziehen, wird in den inneren freien Bereich ein hygroskopisches Material eingebracht. Dieses Material kann aufgestrichen, eingespritzt oder sonst wie deponiert werden.

In einer bevorzugten Weiterbildung der Erfindung wird in den inneren freien Bereich vor der Montage der äußeren Abdeckung Silikagel eingebracht. Silikagel ist ein bekanntes Material um die Bildung von Kondensations-Feuchtigkeit zu verhindern. Gleichzeitig wirkt bei absorbierter Feuchtigkeit ein solches Absorptionsmittel derart, dass konstante Bedingungen für die Detektion vorliegen bleiben. Die Feuchte wird in dem Absorptionsmittel gebunden. Entsprechend kann eine Kalibrierung auf diese Bedingungen dauerhaft angepasst werden. Außerdem reduziert eine solche Absorptionsmitteleinbringung die Einflüsse auf die Bereiche, in denen das Absorptionsmittel angeordnet ist. Werden z.B. Kügelchen aus Silikagel eingebracht, ist die Beeinflussung des Detektionsbereichs einer kapazitiven Sensoranordnung deutlich reduziert. Auf eine dauerhafte und unveränderte Beeinflussung, etwa die durch Absorptionsmittel mit einem absorbierten Material (Wasser) kann das Erfassungssystem mit laufenden Vergleichsmessungen kalibriert werden. Da außerdem die Ausbildung leitender Filme, z.B. durch Flüssigkeiten, über dem Sensor verhindert wird, bleibt die Sensitivität ohne wesentliche Beeinträchtigung.

Die Erfindung wird nun anhand der beiliegenden Figuren näher erläutert.
Figur 1 zeigt eine Seitenansicht auf einen montierten Türgriff;
Figur 2 zeigt den Türgriff aus Figur 1 in einer Schrägansicht;
Figur 3a zeigt den Türgriff aus den Figuren 1 und 2 ohne Abdeckung und mit elektronischen Komponenten;
Figur 3b zeigt den Türgriff aus den Figuren 1 und 2 mit transparent dargestellter Abdeckung und mit elektronischen Komponenten;
Figur 4 zeigt den Türgriff aus den Figuren 1 und 2 mit abgerückter Abdeckung in einer Seitenansicht;
Figur 5 zeigt die Türgriffanordnung aus Figur 4 in einer Schrägansicht.

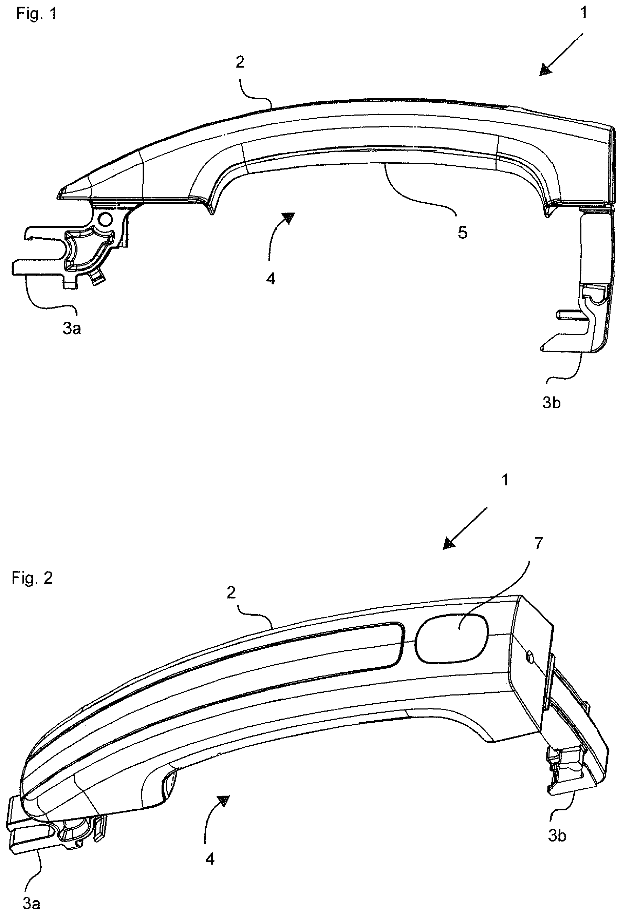

In Figur 1 ist ein Türgriff 1 dargestellt, welcher zur Montage an einem Kraftfahrzeug vorgesehen ist. Der Türgriff weist eine Abdeckung 2 auf, welche auf einen Griffkörper 5 aufgesetzt ist. Betätigungsabschnitte 3a und 3b sind dargestellt. Diese Abschnitte 3a und 3b werden bei der Montage am Fahrzeug durch zugehörige Öffnungen im Türblech gesteckt und treten in Wechselwirkung mit dem mechanischen Schliesskomponenten in der Tür.

Der Türgriff ist so geformt, dass ein Bereich 4 zum Hintergreifen des Türgriffes ausgebildet ist, wobei die Abdeckung 2 zusammen mit einem Griffkörper 5 eine Handhabe bildet.

Figur 2 zeigt den Türgriff aus einer Schrägansicht, so dass die Abdeckung 2 mit ihrer einem Benutzer zugewandten Seite deutlich erkennbar wird. Außerdem ist ein Betätigungsbereich 7 dargestellt, der bei der Montage am Fahrzeug im Bereich der Daumenbetätigung positioniert ist. Über die Interaktion mit diesem Betätigungsbereich 7 kann eine Fahrzeugfunktion ausgelöst werden.

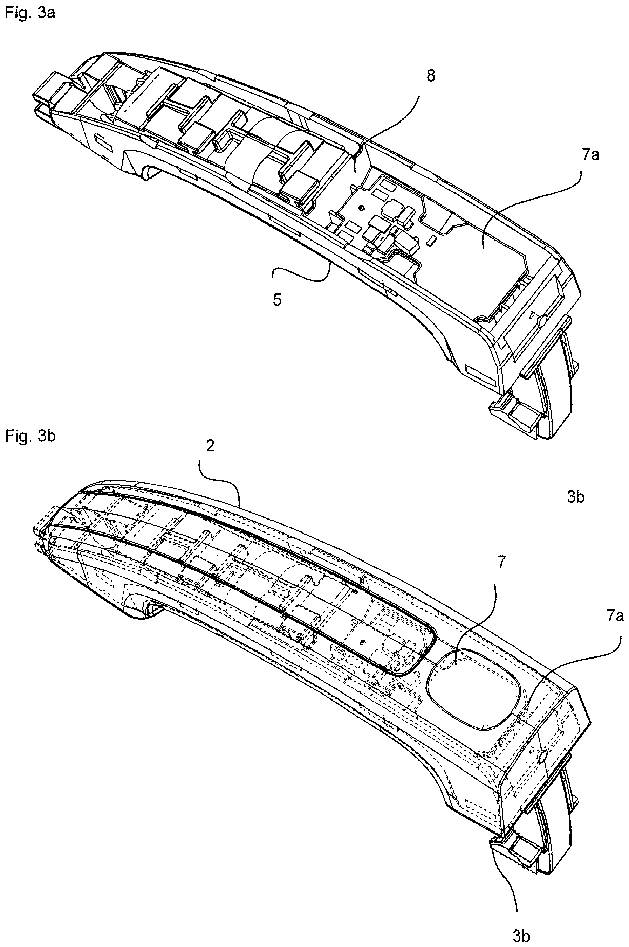

In dem Türgriff 1 können verschiedene Arten von elektronischen Baugruppen angeordnet sein, insbesondere Sensoren und Antennenanordnungen. In Fig. 3a ist der Türgriff in einer Schrägansicht gezeigt, wobei die Abdeckung 2 entfernt ist. Im Griffkörper 5 sind verschiedene elektronische Baugruppen angeordnet. Insbesondere ist im Bereich hinter dem Betätigungsbereich 7 in dem Griff eine kapazitive Sensoranordnung 7a angeordnet. Die Annäherung eines Körperteils, z.B. eines Daumens im Bereich 7 wird durch die darunterliegende Sensoranordnung 7a detektiert. Auf diese Weise kann beispielsweise eine Zentralverriegelung zum Schließen eines abgestellten Fahrzeugs betätigt werden.

Die Figur 3b zeigt, indem die Abdeckung 2 dargestellt ist und die bedeckten Bereiche in unterbrochenen Linien abgebildet sind, dass die Sensoranordnung 7a unter dem Betätigungsbereich 7 liegt.

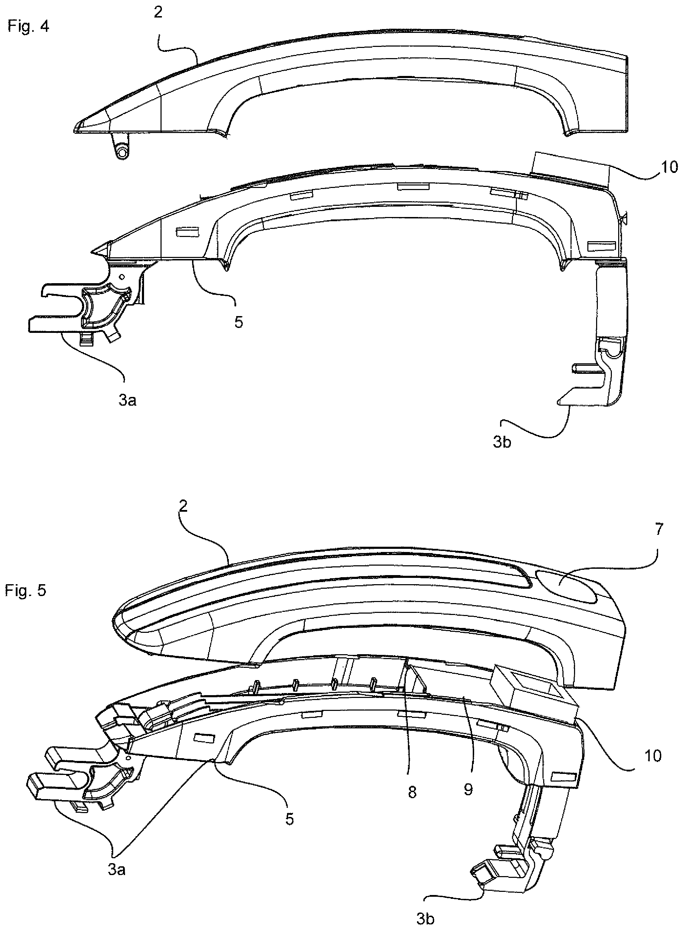

Figur 4 zeigt die Griffanordnung der Figuren 1, 2, und 3b wobei die Abdeckung 2 in dieser Darstellung von dem Griffträger 5 abgerückt ist. Durch die Verwendung mehrerer Bauteile zum Umschließen der im Griff aufgenommenen elektronischen Komponenten ist das Griffinnere nie vollständig abgeschlossen. Luftfeuchtigkeit und Regen sowie Staub und Flüssigkeitsdämpfe können in dem Griff, also zwischen dem Griffträger 5 und die Abdeckung 2 eindringen. Es ist ersichtlich, dass so eindringende Substanzen unter die Betätigungsfläche 7 gelangen können und einen im Griffträger 5 aufgenommenen kapazitiven Sensor 7a beeinflussen.

In Figur 4 ist daher die erfindungsgemäße Dichtung 10 gezeigt, welche zwischen der Griffabdeckung 2 und dem Griffträger 5 komprimiert wird, um den Bereich unterhalb der Abdeckung 7, also den Bereich zwischen Gehäuse 2 und kapazitiver Sensoranordnung zu dichten. Wie in Figur 5 besser zu erkennen ist, weist der Griffkörper 5 im Inneren eine Trennwand 8 auf, die einen Funktionsabschnitt im Inneren des Griffträgers 5 von einem Aufnahmebereich für sonstige Komponenten trennt.

Zur Verdeutlichung des inneren Aufbaus sind die elektronischen Bauteile in Fig. 5 nicht gezeigt. In dem abgetrennten Bereich ist die kapazitive Sensoranordnung 7a angeordnet (siehe Figur 3a und 3b), welche in Figur 5 mit einer Vergussmasse 9 vergossen ist. Auf dieser Vergussmasse ist erfindungsgemäß der dichtende Rahmen 10 angeordnet. Der Rahmen ist mit einer inneren freien Öffnung über der aktiven Sensorfläche des kapazitiven Sensors platziert. Der Sensor ist in dieser Darstellung nicht erkennbar, da er von der Vergussmasse 9 bedeckt ist.

Durch diese erfindungsgemäße Anordnung wird einerseits die Empfindlichkeit des kapazitiven Sensors durch die Dichtung 10 nicht negativ beeinflusst, andererseits wird der Erfassungsbereich der Sensorelektroden von dem Eindringen von Substanzen freigehalten.

In der inneren Öffnung des Dichtmaterials 10 ist absorbierendes Material deponiert, z.B. Kügelchen aus Silikagel.

Bei dem Schaumstoff des Dichtkörpers 10 handelt es sich um einen geschlossen-zelligen Schaumstoff, der das Eindringen und Durchtreten von Flüssigkeiten und Gasen verhindert. Der Schaumstoff ist im Übrigen mit einer einseitigen selbstklebenden Oberfläche versehen, die eine einfache Positionierung und Anbringung erlaubt. Es handelt sich um einen Schaumstoff der so elastisch ist, dass er bei einer Verbindung von Abdeckung 2 und Griffkörper 5 zwischen diesen Komponenten komprimiert wird, dabei eine dichtende Anlage zwischen Vergussmasse 9 und Abdeckung 2 eingeht. Der Schaumstoff ist dabei derart flexibel, dass er keine Demontage behindernden Rückstellkräfte hervorruft.

## Patentansprüche

1. Türgriffeinrichtung (1) für Kraftfahrzeuge,
mit einem Griffkörper (5) und einer Abdeckung (2) für den Griffkörper, wobei der Griffkörper (5) und die Abdeckung (2) eine Handhabe für einen Benutzer bilden, wobei zwischen Griffkörper (5) und Abdeckung (2) ein Aufnahmeraum zur Aufnahme von elektronischen Komponenten gebildet ist,
mit einem kapazitiven Annäherungssensor (7a), welcher in dem Aufnahmeraum angeordnet ist, wobei der Annäherungssensor (7a) eine zu der Abdeckung (2) gerichtete aktive kapazitive Fläche zur Erfassung von Annäherungen aufweist, wobei die Annäherungen durch die Abdeckung (2) erfassbar sind,
wobei die kapazitive Fläche zur Erfassung von Annäherungen mit einer Auswerteschaltung gekoppelt ist, welche Veränderungen in der Kapazität der kapazitiven Fläche erfasst,
wobei in dem Aufnahmeraum ein Dichtmittel (10) angeordnet ist, welches zwischen Abdeckung (2) und Griffkörper (5) oder zwischen Abdeckung (2) und den im Griffkörper (5) aufgenommenen Komponenten dichtend komprimiert ist
**dadurch gekennzeichnet,**
**dass** das Dichtmittel (10) aus einem geschlossen-zelligen Schaumstoff gebildet ist und wenigstens eine vom Rand des Dichtmittels (10) beabstandete durchgehende Öffnung aufweist, wobei die durchgehende Öffnung des Dichtmittels (10) über der aktiven Fläche des Annäherungssensors (7a) angeordnet ist, so dass wenigstens ein Bereich über der aktiven Fläche des Annäherungssensors (7a) frei von Schaumstoff ist.

2. Türgriffeinrichtung nach Anspruch 1, wobei der
kapazitive Annäherungssensor (7a) mit einer elektrisch isolierenden Vergussmasse (9) vergossen ist und wobei das Dichtmittel (10) zwischen Vergussmasse (9) und Abdeckung (2) komprimiert ist.

3. Türgriffeinrichtung nach einem der vorangehenden Ansprüche, wobei in der Öffnung in dem Dichtmittel (10) ein Trockenmittel, insbesondere Silikagel deponiert ist.

4. Türgriffeinrichtung nach einem der vorangehenden Ansprüche, wobei das Dichtmittel (10) nur einen den kapazitiven Annäherungssensor (7a) umgebenden Bereich abdichtet, sich also durch über einen Abschnitt des Aufnahmeraumes erstreckt.

5. Türgriffeinrichtung nach einem der vorangehenden Ansprüche, wobei das Dichtmittel (10) mehrschichtig aufgebaut ist, wobei die in Anlage zu der Abdeckung (2) gelangenden Schichten des Dichtmittels (10) weicher sind als die übrigen Schichten.

## Claims

1. Door handle device (1) for motor vehicles comprising a handle body (5) and a cover (2) for the handle body, wherein the handle body (5) and the cover (2) form a handle for a user, wherein a receiver space for receiving electronic components is formed between the handle body (5) and the cover (2),
comprising a capacitive proximity sensor (7a) which is arranged in the receiver space, wherein the proximity sensor (7a) has an active capacitive surface oriented toward the cover (2) for detecting approaching movements, wherein the approaching movements are able to be detected through the cover (2),
wherein for detecting approaching movements the capacitive surface is coupled to an evaluation circuit which detects alterations in the capacitance of the capacitive surface,
wherein a sealing means (10) is arranged in the receiver space, said sealing means being sealingly compressed between the cover (2) and the handle body (5) or between the cover (2) and the components received in the handle body (5),
**characterised in that** the sealing means (10) is formed from a closed-cell foam and has at least one through-opening which is spaced apart from the edge of the sealing means (10),
wherein the through-opening of the sealing means (10) is arranged above the active surface of the proximity sensor (7a) so that at least one region above the active surface of the proximity sensor (7a) is free of foam.

2. Door handle device according to Claim 1, wherein the capacitive proximity sensor (7a) is cast with an electrically insulating sealing compound (9) and wherein the sealing means (10) is compressed between the sealing compound (9) and the cover (2).

3. Door handle device according to one of the preceding claims, wherein a drying agent, in particular silica gel, is deposited in the opening in the sealing means (10).

4. Door handle device according to one of the preceding claims, wherein the sealing means (10) seals only one region surrounding the capacitive proximity sensor (7a), thus extending above a portion of the receiver space.

5. Door handle device according to one of the preceding claims, wherein the sealing means (10) is of multilayered construction, wherein the layers of the sealing means (10) coming to bear against the cover (2) are more flexible than the remaining layers.

## Revendications

1. Dispositif de poignée de porte (1) pour véhicules automobiles, comportant un corps de poignée (5) et un couvercle (2) pour le corps de poignée, dans lequel le corps de poignée (5) et le couvercle (2) forment une poignée pour un utilisateur, dans lequel entre le corps de poignée (5) et le couvercle (2) un espace de réceptacle pour recevoir des composants électroniques est formé, comportant un détecter de proximité capacitif (7a), qui est disposé dans un espace de réceptacle, dans lequel le détecteur de proximité capacitif (7a) présente une surface capacitive active orientée vers le couvercle (2) pour détecter des rapprochements, dans lequel les rapprochements peuvent être détectés par le couvercle (2), dans lequel la surface capacitive est couplée pour détecter des rapprochements avec un circuit d'estimation, qui détecte des variations de la capacité de la surface capacitive, dans lequel dans l'espace de réceptacle un moyen d'étanchéité (10) est disposé, qui est comprimé de manière étanche entre le couvercle (2) et le corps de poignée (5) ou entre le couvercle (2) et les composants renfermés dans le corps de poignée (5), **caractérisé en ce que** le moyen d'étanchéité (10) est formé à partir d'une mousse à cellules fermées et présente au moins une ouverture traversante espacée du bord du moyen d'étanchéité (10), dans lequel l'ouverture traversante du moyen d'étanchéité (10)est disposée sur la surface active du détecteur de proximité (7a), de sorte que au moins une zone soit exempte de mousse sur la surface active du détecteur de proximité (7a).

2. Dispositif de poignée de porte selon la revendication 1, dans lequel le détecteur de proximité capacitif (7a) est coulé avec une masse de scellement (9) électriquement isolante et dans lequel le moyen d'étanchéité (10) est comprimé entre la masse de scellement (9) et le couvercle (2).

3. Dispositif de poignée de prote selon une des revendications précédentes, dans lequel dans l'ouverture dans le moyen d'étanchéité (10) un moyen de séchage, notamment du gel de silice est déposé.

4. Dispositif de poignée de porte selon une des revendications précédentes, dans lequel le moyen d'étanchéité (10) isole de manière étanche seulement une zone entourant le détecteur de proximité capacitif (7a), s'étend aussi sur une portion de l'espace de réceptacle.

5. Dispositif de poignée de porte selon une des revendications précédentes, dans lequel le moyen d'étanchéité (10) a une structure à plusieurs couches, dans lequel les couches du moyen d'étanchéité (10) venant se positionner sur le couvercle sont plus tendres que les couches restantes.
